(19) Europäisches Patentamt
European Patent Office
Office européen des brevets

(11) **EP 4 212 255 A1**

(12) **EUROPEAN PATENT APPLICATION**
published in accordance with Art. 153(4) EPC

(43) Date of publication:
**19.07.2023 Bulletin 2023/29**

(21) Application number: **21866599.0**

(22) Date of filing: **31.08.2021**

(51) International Patent Classification (IPC):
**B05D 5/12** (2006.01)    **B32B 27/00** (2006.01)
**H01B 1/12** (2006.01)    **H01B 1/20** (2006.01)
**H01B 13/00** (2006.01)

(52) Cooperative Patent Classification (CPC):
**B05D 5/12; B32B 27/00; H01B 1/12; H01B 1/20;
H01B 13/00;** Y02E 10/549

(86) International application number:
**PCT/JP2021/031891**

(87) International publication number:
**WO 2022/054640 (17.03.2022 Gazette 2022/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.09.2020 JP 2020150394**

(71) Applicant: **TOPPAN INC.
Tokyo 110-0016 (JP)**

(72) Inventors:
• **NISHIYAMA, Hiroyoshi
Tokyo 110-0016 (JP)**
• **SHODA, Ryo
Tokyo 110-0016 (JP)**

(74) Representative: **Hoffmann Eitle
Patent- und Rechtsanwälte PartmbB
Arabellastraße 30
81925 München (DE)**

(54) **ORGANIC CONDUCTIVE FILM MANUFACTURING METHOD, ORGANIC CONDUCTIVE FILM, AND LAMINATE**

(57)    A method for producing an organic conductive film includes a step of preparing a coating liquid containing an acid-based organic conductive polymer, an alkali neutralizing agent, and a liquid medium, and having a pH of 4.0 to 6.5 at 25°C, a step of applying the coating liquid to a base layer, and a step of removing the liquid medium from the applied coating liquid.

FIG.1

**Description**

[Technical Field]

The present disclosure relates to organic conductive film production methods, organic conductive films, and laminates.

[Background Art]

In recent years, liquid crystal displays, electroluminescent displays, solar cells, touch panels, and the like are being widely used. These devices include, for example, an indium tin oxide (ITO) laminated as a transparent electrode on a film. Unfortunately, for indium as a material of ITO, there are concerns over global resource depletion and safety, and accordingly, alternative organic materials are being studied. An example of such organic materials is a $\pi$-conjugated conductive polymer, and a specific example of the $\pi$-conjugated conductive polymer is a polythiophene-based conductive polymer.

Regarding the technique of forming a $\pi$-conjugated conductive polymer film, the use of a conductive polymer solution containing a $\pi$-conjugated conductive polymer is known (see, for example, PTL 1).

[Citation List]

[Patent Literature]

PTL 1: JP H07-105718 A

[Summary of Invention]

[Technical Problem]

When a solution is prepared according to PTL 1 and contains an acid-based organic conductive polymer, this solution may be highly acidic due to its composition. In that case, from the viewpoint of ensuring safety, retarding corrosion of a processing apparatus, and the like, the pH of the solution may be adjusted to be a neutral or nearly neutral value using a neutralizing agent or the like. Unfortunately, the inventors have found that a conductive polymer layer formed using a solution with a pH thus adjusted has insufficient light resistance.

The present disclosure has been made in view of the above circumstances; an object thereof is to provide methods for producing highly light-resistant organic conductive films. Another object of the present disclosure is to provide highly light-resistant organic conductive films.

[Solution to Problem]

An intensive study conducted by the inventors revealed that light resistance is affected by the amount of a component derived from an alkali neutralizing agent and remaining in a conductive layer formed from a solution containing an acid-based organic conductive polymer. Based on this finding, the inventors have completed the present invention.

A method according to an aspect of the present disclosure for producing an organic conductive film includes a step of preparing a coating liquid containing an acid-based organic conductive polymer, an alkali neutralizing agent, and a liquid medium, and having a pH of 4.0 to 6.5 at 25°C, a step of applying the coating liquid to a base layer, and a step of removing the liquid medium from the applied coating liquid. Using a coating liquid with a pH thus adjusted allows appropriate control of the quantity of cations contained in an acid-based organic conductive polymer layer and derived from an alkali neutralizing agent, as will be described later, thus enabling production of a highly light-resistant organic conductive film. The study conducted by the inventors thus revealed that it is important for the coating liquid not to have an exceedingly high or low pH, that is, for the acid-based organic conductive polymer layer not to have an exceedingly high or low density of cations derived from an alkali neutralizing agent.

According to an aspect of the production method, the acid-based organic conductive polymer may include a polythiophene-based conductive polymer.

According to an aspect of the production method, the alkali neutralizing agent may include ammonia water.

An organic conductive film according to an aspect of the present disclosure includes a base layer and an acid-based organic conductive polymer layer disposed on the base layer, the acid-based organic conductive polymer layer containing cations derived from an alkali neutralizing agent, wherein the cations contained in the acid-based organic conductive polymer layer have a density of 0.5 to 5.0 mg/cm$^3$. Designing the acid-based organic conductive polymer layer to contain cations derived from an alkali neutralizing agent at a density of 0.5 to 5.0 mg/cm$^3$ allows the organic conductive film to have high light resistance.

According to an aspect of the organic conductive film, the acid-based organic conductive polymer may include a polythiophene-based conductive polymer.

According to an aspect of the organic conductive film, the cations derived from the alkali neutralizing agent may include ammonium ions.

According to an aspect of the organic conductive film, the base layer may include a resin substrate or a glass substrate.

According to an aspect, any of the above organic conductive films may be used as a resistive coating of an electromagnetic wave suppression sheet or as a circuit material in an electronic device.

[Advantageous Effects of Invention]

The present disclosure provides methods for producing highly light-resistant organic conductive films. The present disclosure also provides highly light-resistant organic conductive films. Such organic conductive films can be obtained using the above production methods.

[Brief Description of Drawing]

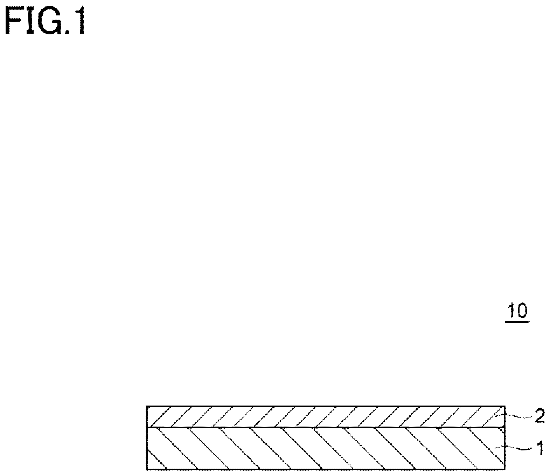

Fig. 1 is a schematic cross-sectional view of an organic conductive film according to an embodiment.

[Description of Embodiments]

Embodiments of the present invention will be described in detail below. The present invention is not limited to the following embodiments.

<Organic conductive film>

Fig. 1 is a schematic cross-sectional view of an organic conductive film according to an embodiment. An organic conductive film 10 includes a base layer 1, and an acid-based organic conductive polymer layer 2 disposed on the base layer 1.

[Base Layer]

The base layer functions as a substrate of the organic conductive film. Examples of materials of the base layer include resin and glass. That is, the base layer may include a resin substrate or a glass substrate, or may be a resin substrate or a glass substrate.

Examples of the resin include, but are not limited to, polyester resins such as polyethylene terephthalate (PET), polybutylene terephthalate (PBT), polyethylene naphthalate, and modified polyester; polyolefin resins such as polyethylene (PE) resin, polypropylene (PP) resin, and cyclic olefin resin; vinyl-based resins such as polyvinyl chloride and polyvinylidene chloride; polyvinyl acetal resins such as polyvinyl butyral (PVB); polyether ether ketone (PEEK) resins; polysulfone (PSF) resins; polyether sulfone (PES) resins; polycarbonate (PC) resins; polyamide resins; polyimide resins; polystyrene resins; acrylic resins; and cellulose triacetate (TAC) resins. Considering availability, cost, and the like, the resin may be a polyester resin such as PET or PBT, or a polyolefin resin such as PP.

Examples of the glass include, but are not limited to, soda-lime glass, lead glass, borosilicate glass, and quartz glass. Considering availability, cost, and the like, the glass may be soda-lime glass.

The base layer may include one or more layers composed of these materials. When the base layer is formed of a plurality of layers (i.e., a laminate), a combination of resin substrates or a combination of resin and glass substrates may be used. Examples of a combination of resin substrates include a PP layer/PET layer and PP layer/PBT layer.

Although the thickness of the base layer is not particularly limited, it may be, for example, 10 to 200 μm, and preferably 25 to 75 μm, in view of transparency and strength according to its use. Further, considering the coating performance of a coating liquid, the adhesion to the polymer layer, and the like, the surface of the base layer may be subjected to corona treatment or adhesion enhancement treatment if necessary.

The base layer may or may not transmit electromagnetic waves at wavelengths in the visible region, depending on the specifications of the organic conductive film. For example, if the organic conductive film is required to transmit electromagnetic waves at wavelengths in the visible region, a base layer may be selected that transmits the electromagnetic waves therethrough. Further, if the substrate is required to have a pattern or a wood-grain design, printing may be performed on the base layer, or undulations may be formed on the surface of the base layer.

[Acid-based organic conductive polymer layer]

The acid-based organic conductive polymer layer is electrically conductive and contains an acid-based organic conductive polymer. As used herein, "acid-based organic conductive polymer" refers to a conductive complex containing a $\pi$-conjugated conductive polymer and a polyanion dopant for the $\pi$-conjugated conductive polymer. Examples of the $\pi$-conjugated conductive polymer include, but are not limited to, polythiophene, polypyrrole, polyaniline, polyacethylene, polyphenylene vinylene, polynaphthalene, and derivatives thereof. Among them, in view of transparency, electrical conductivity, stability, and the like, the $\pi$-conjugated conductive polymer may be a polythiophene-based conductive polymer in particular.

Examples of the polythiophene-based conductive polymer include polythiophene, poly(3-methylthiophene), poly(3-ethylthiophene), poly(3-propylthiophene), poly(3-butylthiophene), poly(3-hexylthiophene), poly(3-heptylthiophene), poly(3-octylthiophene), poly(3-decylthiophene), poly(3-dodecylthiophene), poly(3-octadecylthiophene), poly(3-bromothiophene), poly(3-chlorothiophene), poly(3-iodothiophene), poly(3-cyanothiophene), poly(3-phenylthiophene), poly(3,4-dimethylthiophene), poly(3,4-dibutylthiophene), poly(3-hydroxythiophene), poly(3-methoxythiophene), poly(3-ethoxythiophene), poly(3-butoxythiophene), poly(3-hexyloxythiophene), poly(3-heptyloxythiophene), poly(3-octyloxythiophene), poly(3-decyloxythiophene), poly(3-dodecyloxythiophene), poly(3-octadecyloxythiophene), poly(3,4-dihydroxythiophene), poly(3,4-dimethoxythiophene), poly(3,4-diethoxythiophene), poly(3,4-dipropoxythiophene), poly(3,4-dibutoxythiophene), poly(3,4-dihexyloxythiophene), poly(3,4-diheptyloxythiophene), poly(3,4-dioctyloxythiophene), poly(3,4-didecyloxythiophene), poly(3,4-didodecyloxythiophene), poly(3,4-ethylenedioxythiophene), poly(3,4-propylenedioxythiophene), poly(3,4-butylenedioxythiophene), poly(3-methyl-4-methoxythiophene), poly(3-methyl-4-ethoxythiophene), poly(3-carboxythiophen), poly(3-methyl-4-carboxythiophen), poly(3-methyl-4-carboxyethylthiophen), and poly(3-methyl-4-carboxybutylthiophen). The polythiophene-based conductive polymer may be poly(3,4-ethylenedioxythiophene) in view of electrical conductivity, chemical stability, productivity, and the like.

The polythiophene-based conductive polymers may be used singly or in combination.

The acid-based organic conductive polymer layer contains a polyanion dopant for a $\pi$-conjugated conductive polymer. This improves the electrical conductivity of the acid-based organic conductive polymer layer. Examples of the polyanion dopant include polymer acids having a sulfo group, such as alkanesulfonic acids, polystyrene sulfonic acids, polyvinyl sulfuric acids, polyvinyl sulfonic acids, polyarylsulfonic acids, polyacrylsulfonic acids, polymethacrylsulfonic acids, poly(2-acrylamido-2-methylpropanesulfonic acids), polyisoprenesulfonic acids, polysulphoethyl methacrylate, poly(4-sulfobutyl methacrylate), and polymethacryloxybenzenesulfonic acids; and organic acids having a sulfo group, such as p-toluenesulfonic acids and dodecylbenzenesulfonic acids. The polyanion dopant may be a polystyrene sulfonic acid in terms of chemical stability and electrical conductivity.

The polyanion dopants can be used singly or in combination.

At least part of the polythiophene-based conductive polymer and at least part of the polyanion dopant form a conductive complex in a layer. In view of transparency, electrical conductivity, and the like, the conductive complex may be poly(3,4-ethylenedioxythiophene)-poly(styrenesulfonate)(PEDOT-PSS), which is a complex made of poly(3,4-ethylenedioxythiophene)(PEDOT) and polystyrene sulfonate (PSS).

The acid-based organic conductive polymer layer may further contain another component (e.g., binder or the like) other than the polythiophene-based conductive polymer and the polyanion dopant, unless desired effects are significantly impaired. In that case, the total amount of the polythiophene-based conductive polymer and polyanion dopant in the acid-based organic conductive polymer layer is 50 mass% or more, preferably 80 mass% or more, and more preferably 90 mass% or more.

The thickness of the acid-based organic conductive polymer layer is not particularly limited, but may be, for example, 10 nm to 1 $\mu$m, and preferably 200 to 600 nm.

As will be described later, the acid-based organic conductive polymer layer may be formed by applying, to the base layer, a coating liquid containing an acid-based organic conductive polymer and an alkali neutralizing agent and having a pH of 4.0 to 6.5 at 25°C. From the viewpoint of maintaining high light resistance, the cations contained in the acid-based organic conductive polymer layer and derived from the alkali neutralizing agent has a density of 0.5 to 5.0 mg/cm$^3$, but may be preferably 3.0 to 5.0 mg/cm$^3$, and more preferably 4.5 to 5.0 mg/cm$^3$. The cations are contained in the acid-based organic conductive polymer layer at a density greater than or equal to a certain amount, presumably because cations are trapped due to hydrogen bonding or the like between the cations and the acid-based organic conductive polymer, and the trapped cations remain in the layer after removal of the liquid medium.

The cation content may be measured by ion chromatography. Specifically, the organic conductive film is put into an extractant (ultrapure water) and allowed to stand for 24 hours at 25°C. The extractant after standing is diluted with ultrapure water by a factor of 50, and then cations are quantified by ion chromatography. Based on the quantification results, the quantity of cations remaining in the acid-based organic conductive polymer layer can be calculated.

The cations derived from an alkali neutralizing agent may include ammonium ions. In that case, the quantity of ammonium ions present in the acid-based organic conductive polymer layer, as measured by ion chromatography, is 0.5 to 5.0 mg/cm$^3$, preferably 3.0 to 5.0 mg/cm$^3$, and more preferably 4.5 to 5.0 mg/cm$^3$.

The acid-based organic conductive polymer layer has high light resistance, which means that the surface resistivity thereof will not easily increase over time. The surface resistivity variation in the acid-based organic conductive polymer layer, as measured by four-terminal sensing and represented by the following expression, may be $4.0 \times 10^2$ or less, and more preferably $3.0 \times 10^2$ or less.

$$\text{Surface resistivity variation} = \text{surface resistivity after light resistance test/surface resistivity before light resistance test}$$

Note that the light resistance test is a xenon-type accelerated light resistance test (conditions: irradiance of 60 W/m$^2$, BPT temperature of 63°C, chamber temperature of 40°C, chamber humidity of 50% RH, and test time of 500 hours).

The above organic conductive film may be used as, but is not limited to, a resistive coating of an electromagnetic wave suppression sheet, or a circuit material in an electronic device Note that the organic conductive film is used as with a resistive coating layer described in JP 6523563 B2, serving as an electromagnetic wave suppression sheet. Further, the organic conductive film is used as with a hole-transport layer described in JP 2005-71929 A, serving as an electronic device.

<Electromagnetic wave suppression sheet>

The electromagnetic wave suppression sheet can be a laminate including the organic conductive film, a dielectric layer, and an electromagnetic shielding layer. Examples of methods for producing the electromagnetic wave suppression sheet include, but are not limited to, the following methods:

(1) A method of bonding the organic conductive film to a laminate of a dielectric layer and an electromagnetic shielding layer.
(2) A method of coating a laminate of a dielectric layer and an electromagnetic shielding layer with an acid-based organic conductive polymer layer, and bonding a base layer to the acid-based organic conductive polymer layer.
(3) A method of coating a laminate of a dielectric layer and an electromagnetic shielding layer with an acid-based organic conductive polymer layer, and extruding a base layer onto the acid-based organic conductive polymer layer.

An electromagnetic wave suppression sheet according to an aspect includes a resistive coating, a dielectric layer, and an electromagnetic shielding layer; each of these layers is optically transmissive; and the resistive coating includes an acid-based organic conductive polymer layer. Note that, in another embodiment of the electromagnetic wave suppression sheet, a base layer of the resistive coating may be designed to fully or partly block electromagnetic waves at wavelengths in the visible region.

In an embodiment of the electromagnetic wave suppression sheet, the dielectric layer has a predetermined thickness that allows absorption of electromagnetic waves in a high frequency band of frequencies higher than or equal to those of the millimeter wave band (30 GHz to 300 GHz); the electromagnetic shielding layer is configured as a conductive mesh having an aperture ratio of 35% or more and 85% or less; the total luminous transmittance thereof is 30% or more; and the amount of attenuation of electromagnetic waves in the electromagnetic wave suppression sheet is 20 dB or more.

According to an embodiment of the electromagnetic wave suppression sheet, the electromagnetic shielding layer has a surface resistivity of 0.3 Ω/sq or less.

According to an embodiment of the electromagnetic wave suppression sheet, the resistive coating has a surface resistivity of -15% to +20% relative to vacuum impedance.

<Method for producing organic conductive film>

A method for producing an organic conductive film includes a step of preparing a coating liquid containing an acid-based organic conductive polymer, an alkali neutralizing agent, and a liquid medium, a step of applying the coating liquid to a base layer, and a step of removing the liquid medium from the applied coating liquid.

[Alkali neutralizing agent]

The coating liquid contains an alkali neutralizing agent in addition to the above materials exemplified in relation to the acid-based organic conductive polymer layer. The alkali neutralizing agent is not particularly limited, as long as it can adjust the pH of the coating liquid and does not affect a compound state of the acid-based organic conductive polymer. Examples of the alkali neutralizing agent include hydroxides or carbonates of alkali metals, alkaline-earth metals, or the like; ammonium compounds of ammonia; and amines. Considering availability, the alkali neutralizing agent may include ammonia.

[Liquid medium]

The liquid solvent is not particularly limited; examples thereof include water, organic solvents, solvent mixtures of water and organic solvent, and the like.

The coating liquid has a pH of 4.0 to 6.5 at 25°C. Adjusting the pH thereof to be within this range allows the acid-based organic conductive polymer layer formed to have high light resistance. From this viewpoint, the pH of the coating liquid may be 4.5 to 5.5.

Examples of methods of applying the coating liquid to the base layer include, but are not limited to, known coating techniques, such as gravure coating, reverse roll coating, die coating, air doctor coating, blade coating, rod coating, bar coating, curtain coating, knife coating, transfer roll coating, squeeze coating, impregnation coating, kiss coating, spray coating, calender coating, and extrusion coating.

Examples of methods of removing the liquid medium include heating, decompression, and combinations thereof. If, for example, the liquid medium is removed by heating, the heating temperature may be 50 to 200°C, and more preferably 90 to 150°C. Depending on the heating temperature, the heating time may be, for example, 30 seconds to 15 minutes, and more preferably 1 to 5 minutes.

[Examples]

The present invention will be described in greater detail by way of the following examples, but the present invention is not limited to these examples.

[Preparation of coating liquids]

As an aqueous poly(3,4-ethylenedioxythiophene)-poly(styrenesulfonate)(PEDOT-PSS) dispersion, an aqueous dispersion Clevios PH 1000 (pH = 3) available from Heraeus was prepared. Additionally, as a solution containing an alkali neutralizing agent, ammonia water (pH = 12) available from Kanto Chemical Co., Inc. was prepared. Then, coating liquids 1 to 3 were prepared according to Table 1. Coating liquid 1 was the above aqueous dispersion itself, and coating liquid 2 and coating liquid 3 were each prepared by adding ammonia water to the aqueous dispersion PH 1000 to adjust the pH thereof. The pH of the coating liquids at 25°C was measured with a benchtop pH meter F-37 available from Horiba, Ltd..

[Table 1]

| Coating liquid | pH (25°C) |
| --- | --- |
| 1 | <3 |
| 2 | 5 |
| 3 | 7 |

<Production of organic conductive film>

Each of the above coating liquids was applied with a bar coater #18 to a polyethylene terephthalate substrate (PET; 50 $\mu$m in thickness) to form a coating film thereon. The obtained coating films were heated at 120°C for 1 minute to form a PEDOT-PSS layer (about 300 nm in thickness) on the respective PET substrates. Thus, organic conductive films were produced.

<Evaluation of organic conductive films>

[Cation content in PEDOT-PSS layer]

The ammonium ions remaining in the PEDOT-PSS layers were quantified using an ion chromatography system DX-320 available from Dionex Corporation. Each of the organic conductive films (sample size: 1 cm$^2$ (1 cm $\times$ 1 cm))

was put into an extractant (100 ml of ultrapure water) and allowed to stand for 24 hours at 25°C. Each extractant after standing was diluted with ultrapure water by a factor of 50, and then the ammonium ions therein were quantified by ion chromatography. Based on the quantification results, the quantity of ammonium ions remaining in the PEDOT-PSS layers was calculated. The results are shown in Table 2.

[Surface resistivity variation]

The surface resistivity of the PEDOT-PSS layers before and after the light resistance test was measured at 25°C with a Loresta-GP (MCP-T610; in-line four point probe (ASP) system) available from Mitsubishi Chemical Analytech Co., Ltd.). Three samples of each organic conductive film (sample size: 25 cm$^2$ (5 cm $\times$ 5 cm)) were prepared, and the surface resistivity was measured for each sample five times. The average of the surface resistivities was taken for each set of the three samples of the organic conductive films, and each average was taken as the surface resistivity of the corresponding PEDOT-PSS layer. Then, the surface resistivity variations were calculated using the expression below. The results are shown in Table 2.

$$\text{Surface resistivity variation} = \text{surface resistivity after light resistance test/surface resistivity before light resistance test}$$

(Note that the light resistance test was performed using Xenon Weather Meter X75 available from Suga Test Instruments Co., Ltd. under the following conditions: irradiance of 60 W/m$^2$, BPT temperature of 63°C, chamber temperature of 40°C, chamber humidity of 50% RH, and test time of 500 hours.)

[Table 2]

| | Coating liquid | Cation content (Unit: mg/cm3) | Surface resistivity variation | | |
|---|---|---|---|---|---|
| | | | After 100 hr. | After 250 hr. | After 500 hr. |
| Comp. Ex. 1 | 1 | 0 | 1.8 | 5.9 | 431.2 |
| Example 1 | 2 | 4.8 | 1.9 | 5.7 | 293.7 |
| Comp. Ex. 2 | 3 | 5.5 | 2.1 | 9.6 | 4608.3 |

The surface resistivity variation observed after the elapse of 500 hours was an order of magnitude larger in Comparative Example 2 than in Example 1.
In contrast, the surface resistivity variation in Example 1 was low even after 500 hours had elapsed; specifically, the variation in the surface resistivity was confined within a factor of 300. This value was smaller than that of Comparative Example 1.

[Reference Signs List]

1 ... Base layer
2 ... Acid-based organic conductive polymer layer
10 ... Organic conductive film

Claims

1. A method for producing an organic conductive film, comprising:

a step of preparing a coating liquid containing an acid-based organic conductive polymer, an alkali neutralizing agent, and a liquid medium, and having a pH of 4.0 to 6.5 at 25°C;
a step of applying the coating liquid to a base layer; and
a step of removing the liquid medium from the applied coating liquid.

2. The production method according to claim 1, wherein:
   the acid-based organic conductive polymer includes a polythiophene-based conductive polymer.

3. The production method according to claim 1 or 2, wherein:
   the alkali neutralizing agent includes ammonia.

4. An organic conductive film comprising:

   a base layer; and
   an acid-based organic conductive polymer layer disposed on the base layer, the acid-based organic conductive polymer layer containing cations derived from an alkali neutralizing agent,
   wherein:
   the cations contained in the acid-based organic conductive polymer layer have a density of 0.5 to 5.0 mg/cm$^3$.

5. The film according to claim 4, wherein:
   the acid-based organic conductive polymer includes a polythiophene-based conductive polymer.

6. The film according to claim 4 or 5, wherein:
   the cations derived from the alkali neutralizing agent include ammonium ions.

7. The film according to any one of claims 4 to 6, wherein:
   the base layer includes a resin substrate or a glass substrate.

8. The film according to any one of claims 4 to 7, for use as a resistive coating of an electromagnetic wave suppression sheet or as a circuit material in an electronic device.

9. A laminate comprising:

   a film according to any one of claims 4 to 8;
   a dielectric layer; and
   an electromagnetic shielding layer.

FIG.1

10

2

1

## INTERNATIONAL SEARCH REPORT

| International application No. |
| --- |
| **PCT/JP2021/031891** |

**A. CLASSIFICATION OF SUBJECT MATTER**

*B05D 5/12*(2006.01)i; *B32B 27/00*(2006.01)i; *H01B 1/12*(2006.01)i; *H01B 1/20*(2006.01)i; *H01B 13/00*(2006.01)i
FI:   B05D5/12 B; B32B27/00 A; H01B1/12 F; H01B13/00 503B; H01B1/20 B

According to International Patent Classification (IPC) or to both national classification and IPC

**B. FIELDS SEARCHED**

Minimum documentation searched (classification system followed by classification symbols)

B05D5/12; B32B27/00; H01B1/12; H01B1/20; H01B13/00

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2016-56348 A (SHINETSU CHEMICAL CO) 21 April 2016 (2016-04-21) paragraphs [0079]-[0087], [0106]-[0111], examples, table 1 | 1, 2 |
| A | entire text, all drawings | 3-9 |
| X | JP 2017-101102 A (TOSOH CORP) 08 June 2017 (2017-06-08) paragraphs [0023], [0063], [0073]-[0091], examples | 1-3 |
| A | entire text, all drawings | 4-9 |
| A | JP 2020-59837 A (TOSOH CORP) 16 April 2020 (2020-04-16) entire text, all drawings | 1-9 |
| A | WO 2019/044044 A1 (SHOWA DENKO KK) 07 March 2019 (2019-03-07) entire text, all drawings | 1-9 |
| A | JP 2017-112051 A (TOSOH CORP) 22 June 2017 (2017-06-22) entire text, all drawings | 1-9 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **06 October 2021** | **19 October 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2021/031891**

| Patent document cited in search report | | | Publication date (day/month/year) | Patent family member(s) | Publication date (day/month/year) |
|---|---|---|---|---|---|
| JP | 2016-56348 | A | 21 April 2016 | US 2016/0078977 A1 paragraphs [0077]-[0083], [0104]-[0109], examples, table 1 KR 10-2016-0030853 A TW 201623458 A | |
| JP | 2017-101102 | A | 08 June 2017 | (Family: none) | |
| JP | 2020-59837 | A | 16 April 2020 | (Family: none) | |
| WO | 2019/044044 | A1 | 07 March 2019 | US 2021/0130628 A1 entire text, all drawings EP 3678152 A1 KR 10-2020-0028021 A CN 111052280 A | |
| JP | 2017-112051 | A | 22 June 2017 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H07105718 A
- JP 6523563 B
- JP 2005071929 A